# EUROPEAN PATENT APPLICATION

(11) **EP 4 654 765 A1**
(43) Date of publication of application: **26.11.2025**
(21) Application number: 24206297.4
(22) Date of filing: 13.10.2024
(51) Int. Cl.: H05K 7/14, H05K 7/20

(54) **SUPPORTING DEVICE**

(30) Priority: 23.05.2024 TW 113119282
(71) Applicant: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Ho, Chun-Yi, 821 Kaohsiung City (TW); Wang, Chun-Chiang, 821 Kaohsiung City (TW)
(74) Representative: Straus, Alexander

(57) **Abstract**

A supporting device(20) is provided and includes a first bracket(22), a second bracket(24), a first ventilation hole structure(H1), and a second ventilation hole structure(H2). The first bracket(22) includes a first wall(26a), a second wall(26b) and a lateral wall(28) connected between the first wall(26a) and the second wall(26b). The second bracket(24) is displaceable relative to the first bracket(22) along a longitudinal direction. The first ventilation hole structure(H1) is arranged on the first bracket(22) and includes a first part(P1A) arranged on the first wall(26a) of the first bracket(22) and a second part(P2A) arranged on the lateral wall(28) of the first bracket(22). The second ventilation hole structure(H2) is arranged on the second bracket(24). When the second bracket(24) is located at a predetermined position(K1) relative to the first bracket(22), the first ventilation hole structure(H1) is located in a position corresponding to the second ventilation hole structure(H2).

## Description

### Field of the Invention

The present invention relates to a supporting device according to the pre-characterizing clause of claim 1.

### Background of the Invention

U.S. Patent No. 7,188,916 B2 discloses an adjustable slide rail adapted for a cabinet rack. The adjustable slide rail includes an outer rail portion and an inner rail portion, which are adjustable relative to each other. The outer rail portion and the inner rail portion are configured to be mounted on posts of the cabinet rack and provided with a plurality of ventilation hole structures. The plurality of ventilation hole structures are arranged on lateral walls of the outer rail portion and the inner rail portion. As shown in FIG. 3A, FIG. 3B, FIG. 4A and FIG. 4B of U.S. Patent No. 7,188,916 B2, the ventilation hole structures are in dense arrangements throughout the lateral walls of the outer rail portion and the inner rail portion, which negatively impacts on structural strength of the outer rail portion and the inner rail portion.

### Summary of the Invention

This is mind, the present invention aims at providing a supporting device with improved ventilation design.

This is achieved by a supporting device according to claim 1. The dependent claims pertain to corresponding further developments and improvements.

As will be seen more clearly from the detailed description following below, the claimed supporting device includes a first bracket, a second bracket, at least one first ventilation hole structure, and at least one second ventilation hole structure. The first bracket includes a first wall, a second wall and a lateral wall connected between the first wall and the second wall. The second bracket is displaceable relative to the first bracket along a longitudinal direction. The at least one first ventilation hole structure is arranged on the first bracket. The at least one first ventilation hole structure includes a first part and a second part. The first part of the at least one first ventilation hole structure is arranged on the first wall of the first bracket, and the second part of the at least one first ventilation hole structure is arranged on the lateral wall of the first bracket. The at least one second ventilation hole structure is arranged on the second bracket. When the second bracket is located at a predetermined position relative to the first bracket, the at least one first ventilation hole structure is located at a position corresponding to the at least one second ventilation hole structure.

In contrast to the prior art, the supporting device of the present invention featured by the at least one first ventilation hole structure including the first part arranged on the first wall of the first bracket and the second part arranged on the lateral wall of the first bracket, has enhanced heat dissipation efficiency.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof:
FIG. 1 is a diagram of a supporting device at a first view according to an embodiment of the present invention,
FIG. 2 is an exploded diagram of the supporting device according to the embodiment of the present invention,
FIG. 3 and FIG. 4 are diagrams of the supporting device in different states at a second view according to the embodiment of the present invention,
FIG. 5 is an exploded diagram of a slide rail assembly of the supporting device according to the embodiment of the present invention,
FIG. 6 is a diagram of the supporting device adapted for a rack and configured to support an electronic apparatus according to the embodiment of the present invention,
FIG. 7 is a diagram of the supporting device as a second rail and a third rail are retracted relative to a first rail according to the embodiment of the present invention,
FIG. 8 is a diagram of the supporting device as the second rail and the third rail displace relative to the first rail along a predetermined direction according to the embodiment of the present invention,
FIG. 9 is a diagram of the supporting device as the second rail and the third rail displace relative to the first rail along the predetermined direction to drive a first predetermined feature to be resiliently deformed to accumulate a resilient force according to the embodiment of the present invention, and
FIG. 10 is a diagram of the supporting device as the second rail and the third rail displace relative to the first rail along the predetermined direction to drive the first predetermined feature to release the resilient force according to the embodiment of the present invention according to the embodiment of the present invention.

### Detailed Description

In the following detailed description of the preferred embodiments, reference is made to the accompanying drawings which form a part hereof, and in which is shown by way of illustration specific embodiments in which the invention may be practiced. In this regard, directional terminology, such as "top", "bottom", "left", "right", "front", "back", etc., is used with reference to the orientation of the Figure(s) being described. The components of the present invention can be positioned in a number of different orientations. As such, the directional terminology is used for purposes of illustration and is in no way limiting. Accordingly, the drawings and descriptions will be regarded as illustrative in nature and not as restrictive. Also, if not specified, the term "connect" is intended to mean either an indirect or direct mechanical connection. Thus, if a first device is connected to a second device, that connection may be through a direct mechanical connection, or through an indirect mechanical connection via other devices and connections.

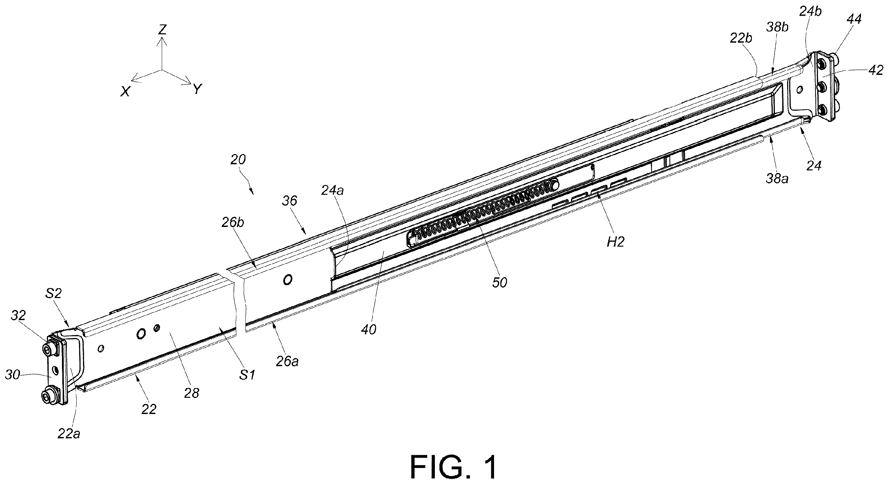

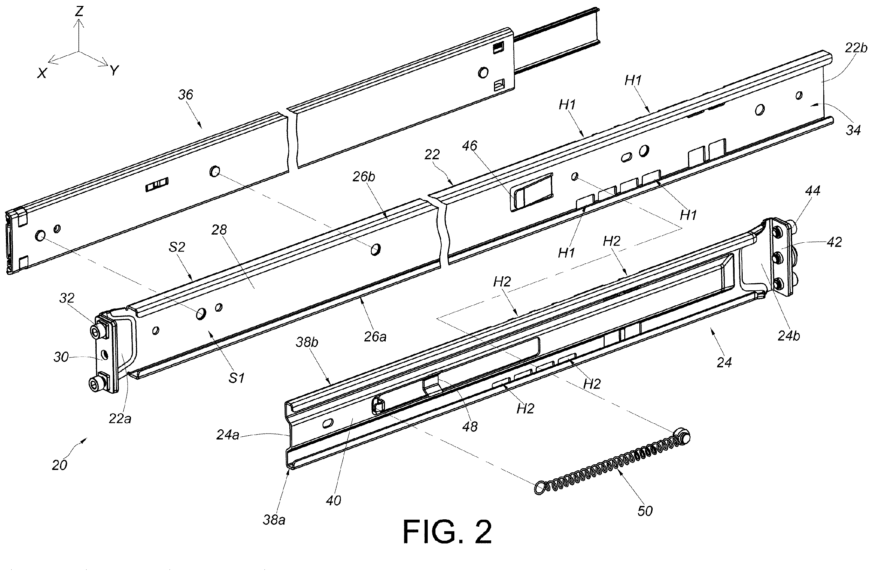

As shown in FIG. 1 and FIG. 2, a supporting device 20 includes a first bracket 22 and a second bracket 24 displaceable relative to the first bracket 22 along a longitudinal direction. In this embodiment, by way of example, the longitudinal direction can be defined by a length direction of a bracket, e.g., the first bracket 22 or the second bracket 24, and parallel to an X axis. A transverse direction can be defined by a lateral direction or a width direction of the bracket, e.g., the first bracket 22 or the second bracket 24, and parallel to a Y axis. A vertical direction can be defined by a height direction of the bracket, e.g., the first bracket 22 or the second bracket 24, and parallel to a Z axis.

The supporting device 20 further includes at least one first ventilation hole structure H1 arranged on the first bracket 22. In this embodiment, by way of examples, the supporting device 20 includes a plurality of first ventilation hole structures H1 arranged at intervals along the longitudinal direction.

Specifically, as shown in FIG. 2 to FIG. 4, the first bracket 22 includes a first wall 26a, a second wall 26b and a lateral wall 28 connected between the first wall 26a and the second wall 26b of the first bracket 22. The first ventilation hole structure H1 includes a first part P1A and a second part P2A, and the first part P1A of the first ventilation hole structure H1 is arranged on one of the first wall 26a and the second wall 26b of the first bracket 22, and the second part P2A of the first ventilation hole structure H1 is arranged on the lateral wall 28 of the first bracket 22.

Preferably, the first part P1A of the first ventilation hole structure H1 on the first wall 26a or the second wall 26b of the first bracket 22 is communicated with the second part P2A of the first ventilation hole structure H1 on the lateral wall 28 of the first bracket 22.

Furthermore, the first bracket 22 or the longitudinal wall 28 of the first bracket 22 includes a first end portion 22a and a second end portion 22b opposite to the first end portion 22a along the longitudinal direction. In this embodiment, by way of examples, the first end portion 22a and the second end portion 22b of the first bracket 22 are a front end portion and a rear end portion of the first bracket 22, respectively. A first end plate 30 is arranged adjacent to the first end portion 22a of the first bracket 22 and substantially perpendicular to the lateral wall 28 of the first bracket 22. At least one first mounting member 32 is arranged on the first end plate 30. Besides, the first bracket 22 or the longitudinal wall 28 of the first bracket 22 includes a first side S 1 and a second side S2 opposite to the first side S1 along the transverse direction.

Preferably, the second bracket 24 is connected to the first side S 1 of the first bracket 22 in an extending or retracting manner along the longitudinal direction. In this embodiment, by way of example, the first wall 26a, the second wall 26b and the lateral wall 28 of the first bracket 22 cooperatively define a channel 34 of the first bracket 22 located at the first side S 1 of the first bracket 22, and an entrance of the channel 34 of the first bracket 22 is located adjacent to the second end portion 22b of the first bracket 22 for allowing the second bracket 24 to be movably mounted on the channel 34 located at the first side S 1 of the first bracket 22. Besides, the supporting device 20 further includes at least one slide rail arranged on the second side S2 of the first bracket 22. In this embodiment, by way of example, the supporting device 20 includes a slide rail assembly 36 arranged on the second side S2 of the first bracket 22 and having a plurality of slide rails displaceable relative to each other along the longitudinal direction.

The supporting device 20 further includes at least one second ventilation hole structure H2 arranged on the second bracket 24. In this embodiment, by way of examples, the supporting device 20 includes a plurality of second ventilation hole structures H2 arranged at intervals along the longitudinal direction. The second ventilation hole structure H2 and the first ventilation hole structure H1 can have substantially identical structures. Specifically, as shown in FIG. 2 to FIG. 4, the second bracket 24 includes a first wall 38a, a second wall 38b and a lateral wall 40 connected between the first wall 38a and the second wall 38b of the second bracket 24. The second ventilation hole structure H2 includes a first part P1B and a second part P2B, and the first part P1B of the second ventilation hole structure H2 is arranged on one of the first wall 38a and the second wall 38b of the second bracket 24, and the second part P2B of the second ventilation hole structure H2 is arranged on the lateral wall 40 of the second bracket 24.

Furthermore, the second bracket 24 or the lateral wall 40 of the second bracket 24 includes a first end portion 24a and a second end portion 24b opposite to the first end portion 24a along the longitudinal direction. In this embodiment, by way of examples, the first end portion 24a and the second end portion 24b of the second bracket 24 are a front end portion and a rear end portion of the second bracket 24, respectively. A second end plate 42 is arranged adjacent to the second end portion 24b of the second bracket 24 and substantially perpendicular to the lateral wall 40 of the second bracket 24. At least one second mounting member 44 is arranged on the second end plate 42. The lateral wall 40 of the second bracket 24 is connected to the channel 34 of the first bracket 22 in an extending or retracting manner along the longitudinal direction, and the second end plate 42 is located outside the channel 34 of the first bracket 22.

Preferably, the first bracket 22 and the second bracket 24 have different longitudinal lengths. In this embodiment, by way of example, a longitudinal length of the lateral wall 28 of the first bracket 22 is greater than a longitudinal length of the lateral wall 40 of the second bracket 24. However, the present invention is not limited to this embodiment.

Preferably, a first blocking portion 46 and a second blocking portion 48 are arranged on the first bracket 22 and the second bracket 24, respectively. The first bracket 22 and the second bracket 24 are configured to block each other, e.g., for preventing detachment of the second bracket 24 from the channel 34 of the first bracket 22.

Preferably, the supporting device 20 further includes a resilient member 50 configured to provide a resilient force to the first bracket 22 and the second bracket 24.

Preferably, the first wall 26a, the second wall 26b and the lateral wall 28 of the first bracket 22 are configured to support the first wall 38a, the second wall 38b and the lateral wall 40 of the second bracket 24.

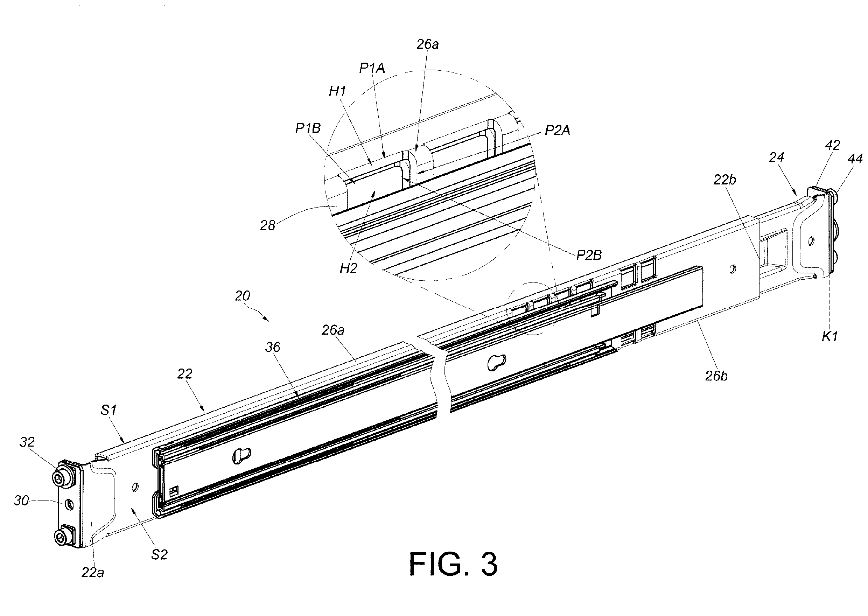

As shown in FIG. 3, when the second bracket 24 is located at a predetermined position K1 relative to the first bracket 22, the first ventilation hole structure H1 is located at a position corresponding to the second ventilation hole structure H2 and communicated with the second ventilation hole structure H2, e.g., the first ventilation hole structure H1 is completely aligned with the second ventilation hole structure H2, so as to allow an air communication between two sides of the supporting device 20 through the first ventilation hole structure H1 and the second ventilation hole structure H2. It should be noticed that, in this embodiment, the first part P1A of the first ventilation hole structure H1 is arranged within a predetermined region of the first wall 26a or the second wall 26b of the first bracket 22, and the second part P2A of the first ventilation hole structure H1 is arranged within a predetermined region of the lateral wall 28 of the first bracket 22.

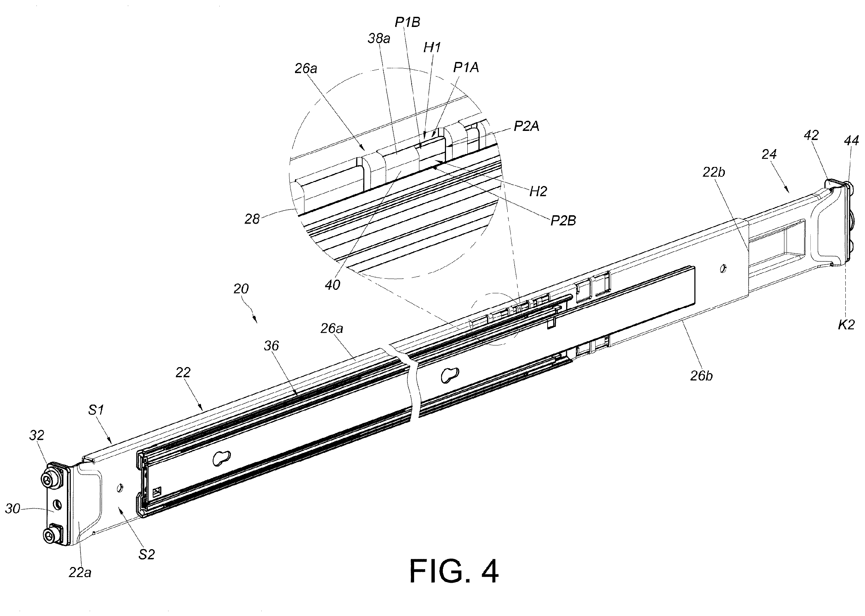

As shown in FIG. 4, when the second bracket 24 is located at another predetermined position K2 relative to the first bracket 22, the first ventilation hole structure H1 is not completely aligned with the second ventilation hole structure H2 and is partially communicated with the second ventilation hole structure H2, e.g., the first ventilation hole structure H1 is partially covered by a portion of the second bracket 24, e.g., the first wall 38a, the second wall 38b or the lateral wall 40 of the second bracket 24, and an uncovered portion of the first ventilation hole structure H1 is communicated with a portion of the second ventilation hole structure H2, such that the air communication between the two sides of the supporting device 20 through the first ventilation hole structure H1 and the second ventilation hole structure H2 is still allowed.

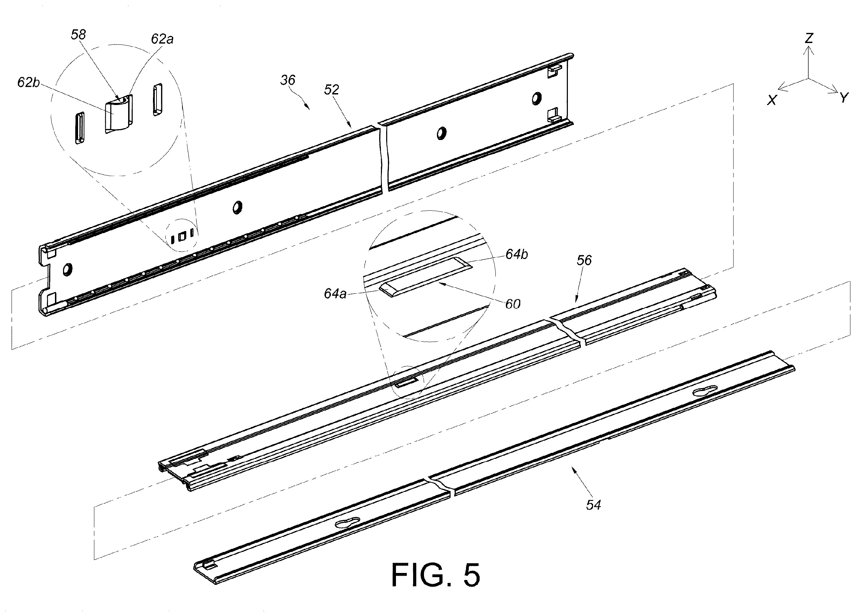

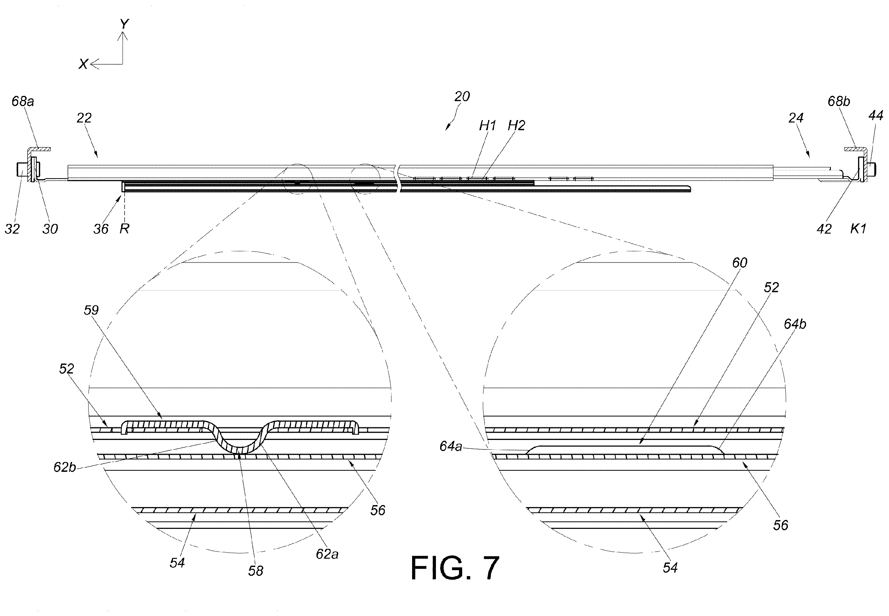

As shown in FIG. 5, the slide rail assembly 36 includes a first rail 52 and a second rail 54 displaceable relative to the first rail 52 along the longitudinal direction. Preferably, the slide rail assembly 36 further includes a third rail 56 movably mounted between the first rail 52 and the second rail 54. In other words, in this embodiment, by way of example, the slide rail assembly 36 includes three slide rails, i.e., the first rail 52, the second rail 54 and the third rail 56. A first predetermined feature 58 is arranged on one of the first rail 52 and the third rail 56. A second predetermined feature 60 is arranged on the other one of the first rail 52 and the third rail 56. The first predetermined feature 58 and the second predetermined feature 60 are configured to cooperate with each other. In this embodiment, by way of example, the first predetermined feature 58 is arranged on the first rail 52, and the second predetermined feature 60 is arranged on the third rail 56. Preferably, as shown in FIG. 7, the first predetermined feature 58 is a protruding portion of an elastic structure 59, e.g., an elastic clip, which is connected to the first rail 52, and the second predetermined feature 60 is a protruding section. The first predetermined feature 58 includes a first guiding surface 62a and a second guiding surface 62b opposite to the first guiding surface 62a along the longitudinal direction. In this embodiment, by way of example, the first guiding surface 62a and the second guiding surface 62b are inclined surfaces or arc surfaces. Furthermore, the second predetermined feature 60 includes a first guiding structure 64a and a second guiding structure 64b opposite to the first guiding structure 64a along the longitudinal direction. In this embodiment, by way of example, the first guiding structure 64a and the second guiding structure 64b are inclined surfaces or arc surfaces.

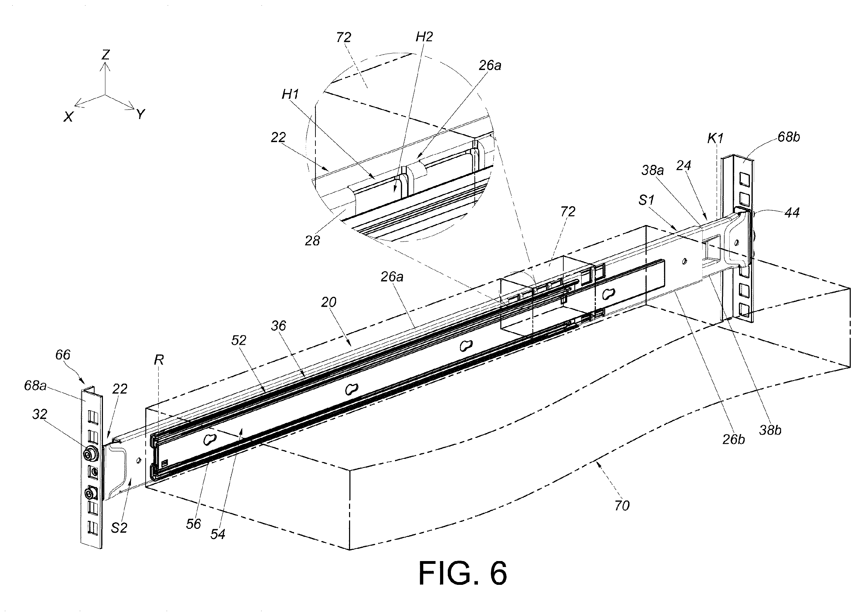

As shown in FIG. 6, the supporting device 20 is adapted for a rack 66. The rack 66 includes a first post 68a and a second post 68b, and the first post 68a and the second post 68b are spaced from each other by a first longitudinal distance. When the second bracket 24 is located at the predetermined position K1, the first mounting member 32 of the first bracket 22 and the second mounting member 44 of the second bracket 24 are configured to be mounted onto the first post 68a and the second post 68b, respectively, and the first ventilation hole structure H1 and the second ventilation hole structure H2 are configured to be aligned with and communicated with each other. Besides, as shown in FIG. 6, the first rail 52 of the slide rail assembly 36 is connected, e.g., fixedly connected, to the second side S2 of the first bracket 22, and the second rail 54 is located at a retracted position R relative to the first rail 52 and configured to support an electronic apparatus 70.

When the first bracket 22 and the second bracket 24 are mounted on the first post 68a and the second post 68b, respectively, the first ventilation hole structure H1 and the second ventilation hole structure H2 are aligned with and communicated with each other, such that the air communication between the two sides of the supporting device 20 through the first ventilation hole structure H1 and the second ventilation hole structure H2 is allowed for dissipating heat generated from a predetermined portion 72 of the electronic apparatus 70.

Since the first ventilation hole structure H1 includes the first part P1A on the first wall 26a or the second wall 26b of the first bracket 22 and the second part P2A on the lateral wall 28 of the first bracket 22 and communicated with the first part P1A, and the second ventilation hole structure H2 includes the first part P1B on the first wall 38a or the second wall 38b of the second bracket 24 and the second part P2B on the lateral wall 40 of the second bracket 24 and communicated with the first part P1B, the heat generated from the predetermined portion 72 of the electronic apparatus 70 can be dissipated through the second part P2A of the first ventilation hole structure H1 and the second part P2B of the second ventilation hole structure H2 transversely, i.e., along the Y axis, and through the first part P1A of the first ventilation hole structure H1 and the first part P1B of the second ventilation hole structure H2 vertically, i.e., along the Z axis.

It should be noticed that when the second bracket 24 is located at the another predetermined position K2, the first mounting member 32 of the first bracket 22 and the second mounting member 44 of the second bracket 24 are respectively configured to be mounted onto a first post and a second post of another rack, which are spaced from each other by a second longitudinal distance different from the first longitudinal distance between the first post 68a and the second post 68b of the rack 66.

As shown in FIG. 7 to FIG. 10, as mentioned above, when the second bracket 24 is located at the predetermined position K1 relative to the first bracket 22 and the first bracket 22 and the second bracket 24 are mounted onto the first post 68a and the second post 68b, respectively, the first ventilation hole structure H1 and the second ventilation hole structure H2 are located at positions corresponding to each other and communicated with each other for dissipating the heat generated from the predetermined portion 72 of the electronic apparatus 70 on the second rail 54.

As shown in FIG. 7, the second rail 54 and the third rail 56 are retracted relative to the first rail 52. Preferably, when the second rail 54 displaces relative to the first rail 52 from the retracted position as shown in FIG. 7 along a predetermined direction D1, e.g., an opening direction D1, the second rail 54 and the third rail 56 can displace synchronously along the predetermined direction D1 by a synchronization mechanism, and then the synchronization mechanism can be terminated by an auxiliary feature on the first rail 52 when the second rail 54 and the third rail 56 displace synchronously for a predetermined distance along the predetermined direction D1. Detailed description for the synchronization mechanism is omitted herein for simplicity.

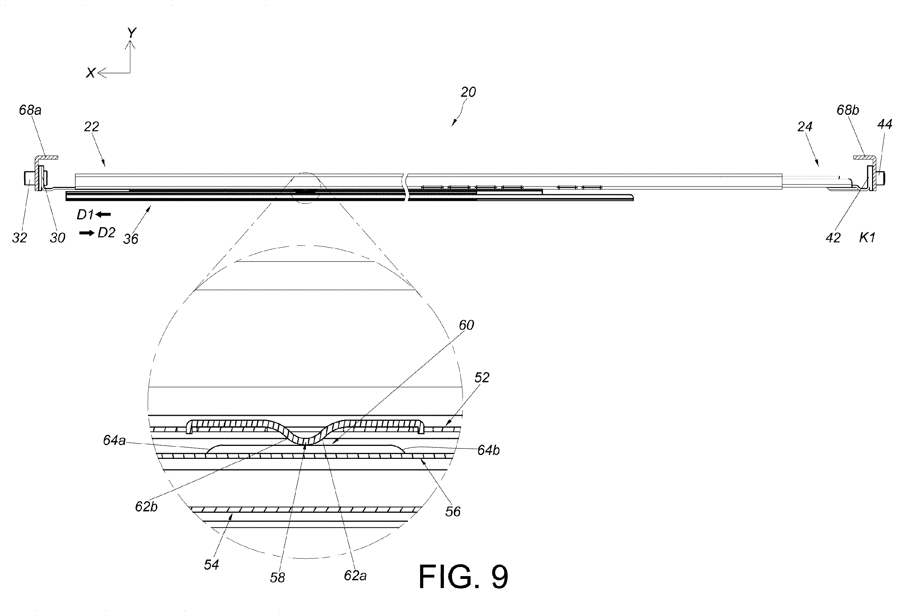

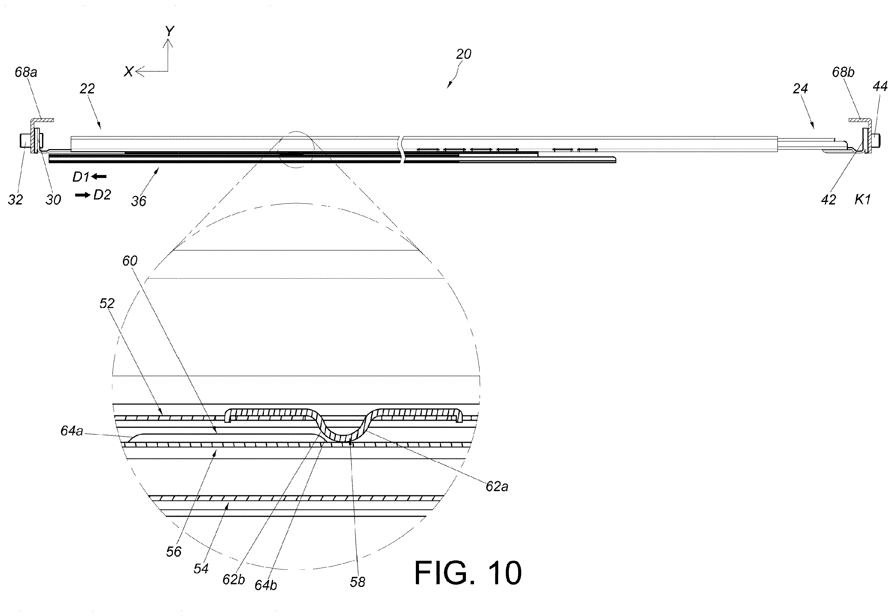

Furthermore, as shown in FIG. 7 to FIG. 10, when the second rail 54 and the third rail 56 displace relative to the first rail 52 along the predetermined direction D1, the first guiding structure 64a of the second predetermined feature 60 can abut against the first guiding surface 62a of the first predetermined feature 58, so as to generate a resistance force for reducing a displacement speed of the third rail 56 and a displacement speed of the second rail 54 relative to the first rail 52 along the predetermined direction D1. As shown in FIG. 9, the first predetermined feature 58 can be resiliently deformed to accumulate a resilient force. As shown in FIG. 10, when the second rail 54 and the third rail 56 further displace relative to the first rail 52 along the predetermined direction D1 to drive the second predetermined feature 60 to pass over the first predetermined feature 58, the first predetermined feature 58 is recovered to release the resilient force. It can be understood that the aforementioned abutment of the first predetermined feature 58 and the second predetermined feature 60 can reduce the displacement speed of the third rail 56 and the displacement speed of the second rail 54 relative to the first rail 52 along the predetermined direction D1, and therefore it can prevent any impact caused by an excessive displacement speed of the second rail 54 or an excessive displacement speed of the electronic apparatus 70 along the predetermined direction D1 so as to achieve safety and/or protective effects.

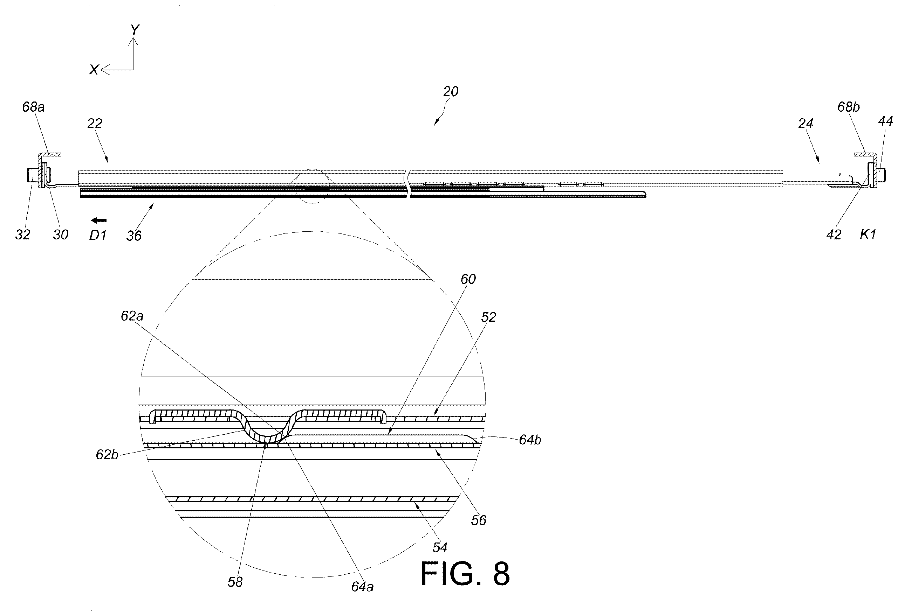

Similarly, as shown in FIG. 10 to FIG. 7, when the second rail 54 and the third rail 56 displace relative to the first rail 52 along another predetermined direction D2, e.g., a retracting direction, which is opposite to the predetermined direction D1, the second guiding structure 64b of the second predetermined feature 60 can abut against the second guiding surface 62b of the first predetermined feature 58, so as to reduce a displacement speed of the third rail 56 and a displacement speed of the second rail 54 relative to the first rail 52 along the another predetermined direction D2 until the second predetermined feature 60 passes over the first predetermined feature 58, e.g., by moving from a position as shown in FIG. 10 to a position as shown in FIG. 8 through a position as shown in FIG. 9. It can be understood that the aforementioned abutment of the first predetermined feature 58 and the second predetermined feature 60 can reduce the displacement speed of the third rail 56 and the displacement speed of the second rail 54 relative to the first rail 52 along the another predetermined direction D2, and therefore it can prevent any impact caused by an excessive displacement speed of the second rail 54 or an excessive displacement speed of the electronic apparatus 70 along the another predetermined direction D2, so as to achieve safety and/or protective effects.

From the above, the supporting device 20 of the present invention includes the following characteristics.
1. The first part P1A of the first ventilation hole structure H1 on the first wall 26a or the second wall 26b of the first bracket 22 is communicated with the second part P2A of the first ventilation hole structure H1 on the lateral wall 28 of the first bracket 22, and the first part P1B of the second ventilation hole structure H2 on the first wall 38a or the second wall 38b of the second bracket 24 is communicated with the second part P2B of the second ventilation hole structure H2 on the lateral wall 40 of the second bracket 24. Therefore, the heat generated from the predetermined portion 72 of the electronic apparatus 70 can be dissipated through the second part P2A of the first ventilation hole structure H1 and the second part P2B of the second ventilation hole structure H2 transversely, i.e., along the Y axis, and through the first part P1A of the first ventilation hole structure H1 and the first part P1B of the second ventilation hole structure H2 vertically, i.e., along the Z axis.
2. When the second rail 54 and the third rail 56 displace relative to the first rail 52 along the predetermined direction D1, the abutment of the first predetermined feature 58 and the second predetermined feature 60 can reduce the displacement speed of the third rail 56 and the displacement speed of the second rail 54 relative to the first rail 52 along the predetermined direction D1 for preventing any impact caused by an excessive displacement speed of the second rail 54 or an excessive displacement speed of the electronic apparatus 70 along the predetermined direction D1, so as to achieve safety and/or protective effects.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A supporting device (20) **characterized by**:
a first bracket (22), the first bracket (22) comprising a first wall (26a), a second wall (26b) and a lateral wall (28) connected between the first wall (26a) and the second wall (26b);
a second bracket (24) displaceable relative to the first bracket (22) along a longitudinal direction;
at least one first ventilation hole structure (H1) arranged on the first bracket (22), the at least one first ventilation hole structure (H1) comprising a first part (P1A) and a second part (P2A), the first part (P1A) of the at least one first ventilation hole structure (H1) being arranged on the first wall (26a) of the first bracket (22), and the second part (P2A) of the at least one first ventilation hole structure (H1) being arranged on the lateral wall (28) of the first bracket (22); and
at least one second ventilation hole structure (H2) arranged on the second bracket (24);
wherein when the second bracket (24) is located at a predetermined position (K1) relative to the first bracket (22), the at least one first ventilation hole structure (H1) is located in a position corresponding to the at least one second ventilation hole structure (H2).

2. The supporting device (20) of claim 1, **characterized in that** the at least one first ventilation hole structure (H1) comprises a plurality of first ventilation hole structures (H1) arranged at intervals along the longitudinal direction.

3. The supporting device (20) of any of claims 1 to 2, **characterized in that** the at least one second ventilation hole structure (H2) and the at least one first ventilation hole structure (H1) have identical structures.

4. The supporting device (20) of any of claims 1 to 3, **characterized in that** the first bracket (22) comprises a first side (S1) and a second side (S2) opposite to the first side (S1), and the second bracket (24) is connected to the first side (S1) of the first bracket (22) in an extending or retracting manner.

5. The supporting device (20) of claim 4, **characterized by** at least one slide rail arranged on the second side (S2) of the first bracket (22) for supporting an electronic apparatus (70).

6. The supporting device (20) of claim 5, **characterized in that** when the second bracket (24) is located at the predetermined position (K1) relative to the first bracket (22), the at least one first ventilation hole structure (H1) and the at least one second ventilation hole structure (H2) are communicated with each other for dissipating heat generated from a predetermined portion (72) of the electronic apparatus (70).

7. The supporting device (20) of any of claims 5 to 6, **characterized in that** the at least one slide rail comprises a first rail (52) connected to the second side (S2) of the first bracket (22), and a second rail (54) displaceable relative to the first rail (52) along the longitudinal direction and configured to support the electronic apparatus (70).

8. The supporting device (20) of claim 7, **characterized in that** the at least one slide rail further comprises a third rail (56) movably mounted between the first rail (52) and the second rail (54).

9. The supporting device (20) of claim 8, further **characterized by** a first predetermined feature (58) and a second predetermined feature (60), the first predetermined feature (58) being arranged on one of the first rail (52) and the third rail (56), the second predetermined feature (60) being arranged on another one of the first rail (52) and the third rail (56), and when the second rail (54) and the third rail (56) displace relative to the first rail (52) along a predetermined direction (D1), the first predetermined feature (58) and the second predetermined feature (60) abutting against each other for reducing a displacement speed of one of the third rail (56) and the second rail (54) relative to the first rail (52) along the predetermined direction (D1).

10. The supporting device (20) of any of claims 1 to 9, **characterized in that** the first bracket (22) and the second bracket (24) have different longitudinal lengths.

11. The supporting device (20) of any of claims 1 to 10, **characterized in that** the first part (P1A) and the second part (P2A) of the at least one first ventilation hole structure (H1) are communicated with each other.

12. The supporting device (20) of any of claims 1 to 11, **characterized in that** the supporting device (20) is adapted for a rack comprising a first post (68a) and a second post (68b), when the first bracket (22) and the second bracket (24) are mounted on the first post (68a) and the second post (68b), respectively, the second bracket (24) is located at the predetermined position (K1) relative to the first bracket (22), such that the at least one first ventilation hole structure (H1) and the at least one second ventilation hole structure (H2) are communicated with each other.

13. The supporting device (20) of any of claims 1 to 12, **characterized in that** the at least one second ventilation hole structure (H2) comprises a first part (P1B) and a second part (P2B), the first part (P1B) of the at least one second ventilation hole structure (H2) is arranged on a first wall (38a) of the second bracket (24), and the second part (P2B) of the at least one second ventilation hole structure (H2) is arranged on a lateral wall (40) of the second bracket (24).

14. The supporting device (20) of claim 13, **characterized in that** when the second bracket (24) is located at the predetermined position (K1) relative to the first bracket (22), the first part (P1A) and the second part (P2A) of the at least one first ventilation hole structure (H1) are located at positions corresponding to the first part (P1B) and the second part (P2B) of the at least one second ventilation hole structure (H2), respectively, for allowing air communication through the first part (P1A) of the at least one first ventilation hole structure (H1) and the first part (P1B) of the at least one second ventilation hole structure (H2) along a transverse direction perpendicular to the longitudinal direction and through the second part (P2A) of the at least one first ventilation hole structure (H1) and the second part (P2B) of the at least one second ventilation hole structure (H2) a vertical direction perpendicular to the longitudinal direction and the transverse direction.

15. The supporting device (20) of any of claims 1 to 14, **characterized in that** when the second bracket (24) is located at the predetermined position (K1) relative to the first bracket (22), the at least one first ventilation hole structure (H1) is completely aligned with the at least one second ventilation hole structure (H2).

## Amended claims

### Amended claims in accordance with Rule 137(2) EPC.

1. A supporting device (20) comprising:
a first bracket (22), the first bracket (22) comprising a first wall (26a), a second wall (26b) and a lateral wall (28) connected between the first wall (26a) and the second wall (26b); and
a second bracket (24) displaceable relative to the first bracket (22) along a longitudinal direction; and
the supporting device (20) **characterized by**:
at least one first ventilation hole structure (H1) arranged on the first bracket (22), the at least one first ventilation hole structure (H1) comprising a first part (P1A) and a second part (P2A), the first part (P1A) of the at least one first ventilation hole structure (H1) being arranged on the first wall (26a) of the first bracket (22), and the second part (P2A) of the at least one first ventilation hole structure (H1) being arranged on the lateral wall (28) of the first bracket (22); and
at least one second ventilation hole structure (H2) arranged on the second bracket (24);
wherein when the second bracket (24) is located at a predetermined position (K1) relative to the first bracket (22), the at least one first ventilation hole structure (H1) is located in a position corresponding to the at least one second ventilation hole structure (H2).

2. The supporting device (20) of claim 1, **characterized in that** the at least one first ventilation hole structure (H1) comprises a plurality of first ventilation hole structures (H1) arranged at intervals along the longitudinal direction.

3. The supporting device (20) of any of claims 1 to 2, **characterized in that** the at least one second ventilation hole structure (H2) and the at least one first ventilation hole structure (H1) have identical structures.

4. The supporting device (20) of any of claims 1 to 3, **characterized in that** the first bracket (22) comprises a first side (S1) and a second side (S2) opposite to the first side (S1), and the second bracket (24) is connected to the first side (S1) of the first bracket (22) in an extending or retracting manner.

5. The supporting device (20) of claim 4, **characterized by** at least one slide rail arranged on the second side (S2) of the first bracket (22) for supporting an electronic apparatus (70).

6. The supporting device (20) of claim 5, **characterized in that** when the second bracket (24) is located at the predetermined position (K1) relative to the first bracket (22), the at least one first ventilation hole structure (H1) and the at least one second ventilation hole structure (H2) are communicated with each other for dissipating heat generated from a predetermined portion (72) of the electronic apparatus (70).

7. The supporting device (20) of any of claims 5 to 6, **characterized in that** the at least one slide rail comprises a first rail (52) connected to the second side (S2) of the first bracket (22), and a second rail (54) displaceable relative to the first rail (52) along the longitudinal direction and configured to support the electronic apparatus (70).

8. The supporting device (20) of claim 7, **characterized in that** the at least one slide rail further comprises a third rail (56) movably mounted between the first rail (52) and the second rail (54).

9. The supporting device (20) of claim 8, further **characterized by** a first predetermined feature (58) and a second predetermined feature (60), the first predetermined feature (58) being arranged on one of the first rail (52) and the third rail (56), the second predetermined feature (60) being arranged on another one of the first rail (52) and the third rail (56), and when the second rail (54) and the third rail (56) displace relative to the first rail (52) along a predetermined direction (D1), the first predetermined feature (58) and the second predetermined feature (60) abutting against each other for reducing a displacement speed of one of the third rail (56) and the second rail (54) relative to the first rail (52) along the predetermined direction (D1).

10. The supporting device (20) of any of claims 1 to 9, **characterized in that** the first bracket (22) and the second bracket (24) have different longitudinal lengths.

11. The supporting device (20) of any of claims 1 to 10, **characterized in that** the first part (P1A) and the second part (P2A) of the at least one first ventilation hole structure (H1) are communicated with each other.

12. The supporting device (20) of any of claims 1 to 11, **characterized in that** the supporting device (20) is adapted for a rack comprising a first post (68a) and a second post (68b), when the first bracket (22) and the second bracket (24) are mounted on the first post (68a) and the second post (68b), respectively, the second bracket (24) is located at the predetermined position (K1) relative to the first bracket (22), such that the at least one first ventilation hole structure (H1) and the at least one second ventilation hole structure (H2) are communicated with each other.

13. The supporting device (20) of any of claims 1 to 12, **characterized in that** the at least one second ventilation hole structure (H2) comprises a first part (P1B) and a second part (P2B), the first part (P1B) of the at least one second ventilation hole structure (H2) is arranged on a first wall (38a) of the second bracket (24), and the second part (P2B) of the at least one second ventilation hole structure (H2) is arranged on a lateral wall (40) of the second bracket (24).

14. The supporting device (20) of claim 13, **characterized in that** when the second bracket (24) is located at the predetermined position (K1) relative to the first bracket (22), the first part (P1A) and the second part (P2A) of the at least one first ventilation hole structure (H1) are located at positions corresponding to the first part (P1B) and the second part (P2B) of the at least one second ventilation hole structure (H2), respectively, for allowing air communication through the first part (P1A) of the at least one first ventilation hole structure (H1) and the first part (P1B) of the at least one second ventilation hole structure (H2) along a transverse direction perpendicular to the longitudinal direction and through the second part (P2A) of the at least one first ventilation hole structure (H1) and the second part (P2B) of the at least one second ventilation hole structure (H2) a vertical direction perpendicular to the longitudinal direction and the transverse direction.

15. The supporting device (20) of any of claims 1 to 14, **characterized in that** when the second bracket (24) is located at the predetermined position (K1) relative to the first bracket (22), the at least one first ventilation hole structure (H1) is completely aligned with the at least one second ventilation hole structure (H2).
